# EUROPEAN PATENT APPLICATION

(11) **EP 4 790 361 A1**
(43) Date of publication of application: **12.08.2026**
(21) Application number: 24873884.1
(22) Date of filing: 18.07.2024
(51) Int. Cl.: G01B 15/04, G01N 23/201

(54) **ANALYSIS DEVICE, ANALYSIS METHOD, AND ANALYSIS PROGRAM**

(30) Priority: 02.10.2023 JP 2023171642
(71) Applicant: Rigaku Corporation, Akishima-shi Tokyo 196-8666 (JP)
(72) Inventor: ITO Yoshiyasu, Tokyo 196-8666 (JP)
(74) Representative: Maiwald GmbH
(86) International application number: PCT/JP2024/025826
(87) International publication number: WO 2025/074709

(57) **Abstract**

An analysis apparatus, an analysis method, and an analysis program capable of accurately analyzing a scattering body having a complicated cross-sectional shape and improving the robustness of the analysis are provided. An initial information setting section 124c for setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample, an intensity calculating section 126 for calculating the scattering intensity of the X-ray scattered by the plate-shaped sample based on the cross-sectional shape of the layer, a fitting section 127 for fitting the calculated scattering intensity with the measured scattering intensity, and a parameter determining section 128 for determining the angles and radii representing a cross-sectional shape of the layer by the result of the fitting, are comprised, wherein the fitting section repeats fitting by changing the cross-sectional shape of the layer.

## Description

### RELATED ART

### Field of the Invention

The present invention relates to an analysis apparatus, an analysis method, and an analysis program for a fine structure in a plate-shaped sample formed by periodically arranging scattering bodies long in a thickness direction.

### Description of the Related Art

As an analysis method for finely-processed pattern shape formed by a periodically arranged scattering bodies long in the thickness direction of a plate-shaped sample, a method is known in which a scattering body is sliced at each position in the depth direction and the position of the centroid and the size of each sliced layer are calculated (see Patent Document 1). In such a method, unlike an analysis for determining a parameter representing a predetermined model such as an elliptic cylinder, an analysis capable of arbitrary expressing the position of the centroid and the size with respect to the depth direction is introduced.

### Patent Document

Patent Document 1: JP 7100897 B

### SUMMARY OF THE INVENTION

However, in the method described in Patent Document 1, the cross-sectional shape of each layer in the scattering body is approximated by a predetermined shape such as a circle, an ellipse or a square. In such an analysis, when the scattering body has an arbitrary shape in which a cross section cannot be expressed in a predetermined shape (a circle, an ellipse, or a square) or a shape in which a cross section of a predetermined shape is changed along a depth direction, a correct analysis result cannot be obtained. For example, processed shapes of semiconductor devices in recent years are becoming more complicated, and in a transmission CD-SAXS, a scene in which processed shapes cannot be analyzed by a simple shape model is increasing. In particular, at the product development stage, scattering bodies having complex cross-sectional shapes, whether intended or not, can be formed. In such a situation, it is important to accurately recognize the shape of the scattering body.

The present invention has been made in view of such circumstances, and an object thereof is to provide an analysis apparatus, an analysis method, and an analysis program capable of accurately analyzing a scattering body having a complicated cross-sectional shape and improving the robustness of analysis.
(1) In order to achieve the above object, an analysis apparatus of the present invention is an analysis apparatus for analyzing a fine structure of a plate-shaped sample formed by periodically arranging scattering bodies long in a thickness direction, comprising a measurement data storing section for storing data of scattering intensity of X-rays scattered from the plate-shaped sample measured by transmitting X-rays at a plurality of ω rotation angles, an initial information setting section for setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample, an intensity calculating section for calculating the scattering intensity of the X-ray scattered by the plate-shaped sample based on the cross-sectional shape of the layer, a fitting section for fitting the calculated scattering intensity with the measured scattering intensity, and a parameter determining section for determining the angles and radii representing a cross-sectional shape of the layer by the result of the fitting, wherein the fitting section repeats fitting by changing the cross-sectional shape of the layer.
(2) Further, in the analysis apparatus according to (1), the intensity calculating section calculates the scattering intensity under the condition that the shapes of the respective layers constituting the scattering body are similar to each other.
(3) In the analysis apparatus according to (1) or (2), the initial information setting section sets a predetermined shape as the initial cross-sectional shape of the layer.
(4) Further, in the analysis apparatus according to (1) or (2), the initial information setting section sets a shape designated by a user as the initial cross-sectional shape of the layer.
(5) Further, the analysis apparatus according to (4) further comprises an input information converting section for converting the shape designated by the user into the initial cross-sectional shape of the layer using a freeform tool.
(6) Further, in the analysis apparatus according to (1) or (2), the initial information setting section uses a shape set using image data of the plate-shaped sample as the initial cross-sectional shape of the layer.
(7) Further, in the analysis apparatus according to (1) or (2), the initial information setting section uses a shape determined by a parameter obtained by model-based analysis as the initial cross-sectional shape of the layer.
(8) Further, in the analysis apparatus according to any one of (1) to (7), the parameter determining section calculates centroid positions of the cross-sectional shapes of the respective layers as relative positions with respect to the origin.
(9) Further, in the analysis apparatus according to any one of (1) to (8), the parameter determining section determines the condition for using a model-based analysis in which a cross-sectional shape of the layer is assumed to be constant, based on the angles and radii representing the determined cross-sectional shape of the layer.
(10) Further, the analysis method of the present invention is an analysis method for analyzing a fine structure of a plate-shaped sample formed by periodically arranging scattering bodies long in a thickness direction, comprises the steps of preparing data of scattering intensity of X-rays scattered from the plate-shaped sample measured by transmitting X-rays at a plurality of ω rotation angles, setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample, calculating the scattering intensity of the X-ray scattered by the plate-shaped sample based on the cross-sectional shape of the layer, fitting the calculated scattering intensity with the measured scattering intensity, and determining the angles and radii representing a cross-sectional shape of the layer by the result of the fitting.
(11) Further, the analysis program of the present invention is an analysis program for analyzing a fine structure of a plate-shaped sample formed by periodically arranging scattering bodies long in a thickness direction, causing a computer to execute the process of: preparing data of scattering intensity of X-rays scattered from the plate-shaped sample measured by transmitting X-rays at a plurality of ω rotation angles, setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample, calculating the scattering intensity of the X-ray scattered by the plate-shaped sample based on the cross-sectional shape of the layer, fitting the calculated scattering intensity with the measured scattering intensity, and determining the angles and radii representing a cross-sectional shape of the layer by the result of the fitting.

### Brief Description of the Drawings

FIG. 1 is a perspective view showing a measuring system of a transmission CD-SAXS.
FIGS. 2A and 2B are an XY cross-sectional view and an XZ cross-sectional view of a plate-shaped sample in electron number density distribution, respectively.
FIGS. 3A and 3B are diagrams showing hole shapes in XZ and YZ planes representing the analysis conditions, respectively.
FIG. 4 is a diagram showing a cross-sectional shape of a slice layer of a scattering body.
FIG. 5 is a diagram showing a cross-sectional shape with Rk represented by a multivalued function of θk.
FIG. 6 is a block diagram showing a configuration of a measurement system according to the present invention.
FIG. 7 is a plan view showing a configuration of a measurement apparatus.
FIG. 8 is a diagram showing an example in which a shape obtained by model-free analysis is approximated by an elliptical model.
FIG. 9 is a flowchart showing a method of measurement and analysis according to the present invention.
FIG. 10 is a flowchart showing selection of a cross-sectional shape setting method according to the present invention.
FIG.11 is a diagram showing magnification ratios for respective slice layers of a scattering body.
FIG. 12 is a diagram showing a figure set by a freeform tool.
FIG. 13 is a diagram showing respective cross-sectional shapes of a scattering body set as a true shape.
FIG. 14 is a graph showing scattering profiles performed fitting by assuming a constant ellipse as a cross-sectional shape with respect to measured scattering profiles in Q_{Z} direction.
FIG. 15 is a graph showing scattering profiles performed fitting by assuming a model-free shape as a cross-sectional shape with respect to measured scattering profiles in Q_{Z} direction.
FIGS. 16A and 16B are graphs of scattering profiles performed fitting by assuming a constant ellipse and a model-free shape as respective cross-sectional shapes in Q_{R} direction, respectively.
FIG. 17 is a diagram showing cross-sectional shapes at i=5 of a scattering body performed fitting by assuming a constant ellipse and a model-free shape as a cross-sectional shape.
FIG. 18 is a diagram showing cross-sectional shapes at i=15 of a scattering body performed fitting by assuming a constant ellipse and a model-free shape as a cross-sectional shape.
FIG. 19 is a diagram showing cross-sectional shapes at i=25 of a scattering body performed fitting by assuming a constant ellipse and a model-free shape as a cross-sectional shape.
FIG. 20 is a diagram showing respective cross-sectional shapes of a scattering body set as a true shape.
FIG. 21 is a graph showing scattering profiles performed fitting by assuming a constant circle as a cross-sectional shape with respect to measured scattering profiles in Q_{Z} direction.
FIG. 22 is a graph showing scattering profiles performed fitting by assuming a model-free shape as a cross-sectional shape with respect to measured scattering profiles in Q_{Z} direction.
FIGS. 23A and 23B are graphs of scattering profiles performed fitting by assuming a constant circle and a model-free shape as respective cross-sectional shapes in Q_{R} direction, respectively.

### DETAILED DESCRIPTION OF THE INVENTION

Next, embodiments of the present invention are described with reference to the drawings. To facilitate understanding of the description, the same reference numerals are assigned to the same components in the respective drawings, and duplicate descriptions are omitted.

### [Principle]

### (Transmission CD-SAXS)

In the present invention, the shapes or the like of the scattering bodies in the sample by a transmission CD-SAXS that can be performed at a laboratory level are analyzed. In particular, it is suitable for analyzing shapes of semiconductor devices having finely-processed patterns with deep grooves, such as three-dimensional NAND and DRAM. The present invention is premised on an analysis method that finely slices in a depth direction and provides a diameter or a position fluctuation as a parameter to each depth.

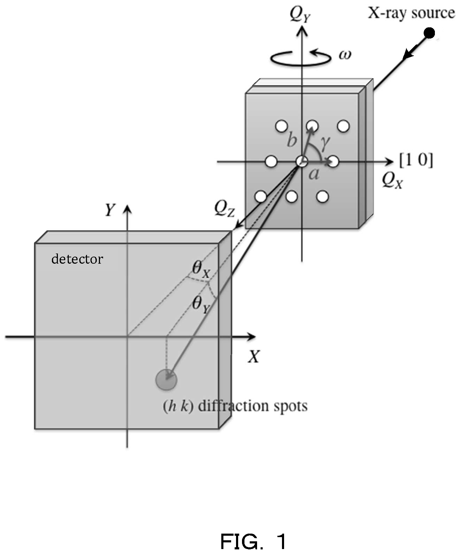

FIG. 1 is a perspective view showing a measuring system of a transmission CD-SAXS. In a transmission CD-SAXS, sample rotation (ω rotation) is performed with respect to a direction in which X-rays are incident perpendicularly to the sample surface, and the dependency of the integrated intensity of the diffracted ray to the sample rotation angle is measured. The ω-axis is the sample rotational axis perpendicular to the X-ray incident direction, and Q_{Y} axis coincides with the ω-axis. The purpose of rotating the sample is to change the scattering vector Q_{Z} to acquire depth direction information. ΔQ_{Z} in the transmission mode is 1/100 to 1/1000 times smaller than ΔQ_{Z} in the reflection mode and is therefore useful for analysis of deep holes or grooves.

### (Small Angle X-ray Scattering Intensity)

As described above, in the transmission CD-SAXS with little effect of refraction and multiple reflection, the small angle X-ray scattering intensity I(Q) can be calculated by the Born approximation (the square of the absolute value of the Fourier transform of the electron number density distribution ρ(r) in the whole system).

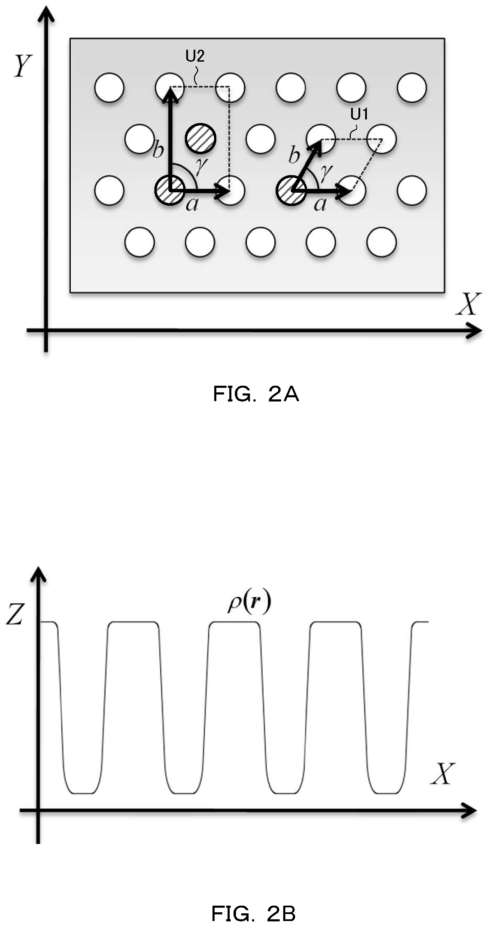

FIGS. 2A and 2B are an XY cross-sectional view and an XZ cross-sectional view of a plate-shaped sample in electron number density distribution, respectively. If the scattering bodies have a periodic-pattern configuration, as shown in FIGS. 2A and 2B, the magnitude of the scattered X-ray can be described by the integral of the unit-cell and the product of the Laue function L. Then, a Q_{X} and Q_{Y} satisfying the diffraction condition are derived from the Laue function.

### (Shape of Scattering body)

In FIG. 2A, the individual sites of the respective unit-cells are indicated by hatched circles. In the case of a common electron density distribution and shape at all respective sites, the integral in the unit cell, which represents the scattering amplitude in the unit cell, can be described by the product of the scattering body shape factor F, which is the integral of one scattering body, and the structural factor S.

It is important to determine the shape (electron number density distribution) of the scattering body when the pattern structure of the scattering bodies is determined by the pattern of the mask as in the semiconductor device. A factor related to the shape of the scattering body is no other than the shape factor F that is the shape integral of the scattering body.

Since the actual shape of the scattering body cannot be approximated by a simple shape such as a cylindrical, it is effective to analyze the actual shape of the scattering body by using a shape factor incorporated in the parameter for each slice layer which is sliced with respect to the depth direction. The shape can be determined by refining the model parameters so that the calculated data with the model parameters as variables coincide with the experimental data. At this time, an analysis performed by assuming that the cross-sectional shape of each layer is a predetermined shape such as a circle, an ellipse, or a square is called a model-based analysis, and an analysis in which the cross-sectional shape of each layer is arbitrary is called a model-free analysis.

### [Model-Free Analysis]

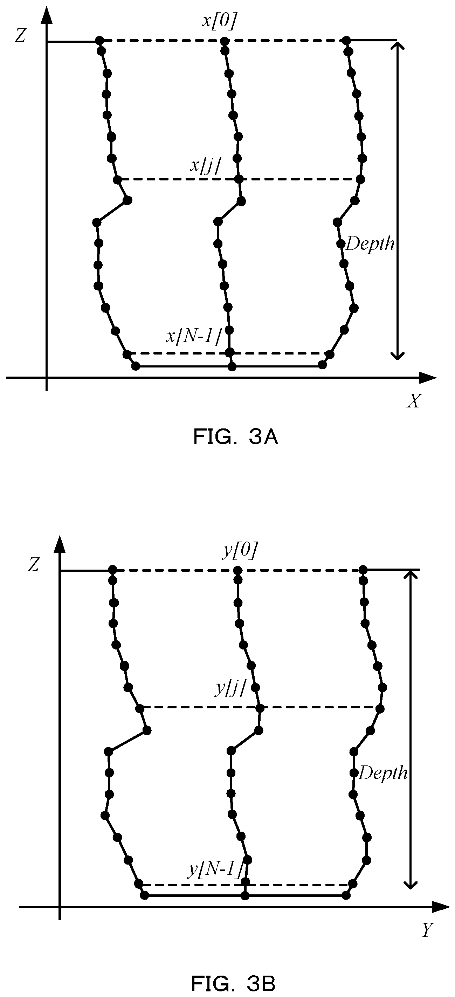

The scattering intensity of the X-rays by the plate-shaped sample can be calculated under the condition that the scattering body is formed by stack of layers having respective cross-sectional shapes (XY cross-sectional shapes) with respect to the thickness direction of the plate-shaped sample. For example, the hole has the depth, which is set as a parameter, and is sliced into N equal layers with respect to the depth direction. FIGS. 3A and 3B are diagrams showing hole shapes in XZ and YZ planes representing the analysis conditions, respectively.

In the model-free analysis, one rotation (2π) is divided into N equal parts, and the distance Rk to the boundary surface is given as a variable for each θk=2πk/N, and arbitrary X-Y cross-sectional shape is expressed. In the analysis, any X-Y cross-sectional shape can be obtained by optimizing Rk. For the j-th slice layer, the density ρ[j], the thickness t[j] and the origin position of the scattering body (ΔX[j], ΔY[j]) can be given as variables. Note that x[j] and y[j] in FIG. 3 indicate the position of the centroid of the j-th slice layer.

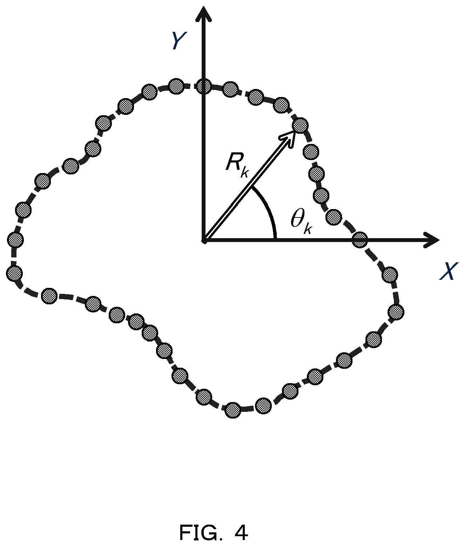

FIG. 4 is a diagram showing a cross-sectional shape of a slice layer of a scattering body. Each slice layer of the scattering body is specified by angles, radii and a position of a centroid of the cross-sectional shape representing a cross-sectional shape when an origin position is set as a center. Thus, a complicated shape can be represented. For example, when the position of the centroid is expressed as (X, Y), the position and the shape of the hole are given by the origin position (X+ΔX, Y+ΔY) with respect to the centroid position (X, Y) and the parameters (θk, Rk) of the angles and the radii. It should be noted that the cross-sectional shape in which Rk is represented with the multivalued function of θk is not handled, and it is preferable that the user cannot designate such a shape as an initial cross-sectional shape.

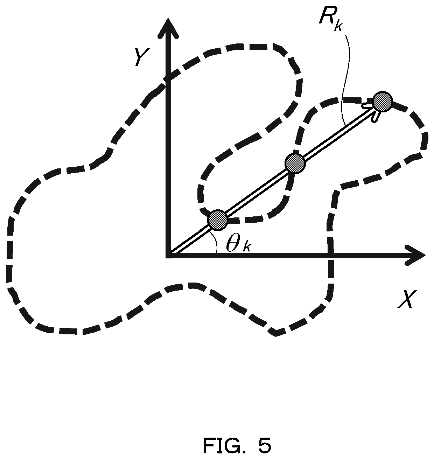

FIG. 5 is a diagram showing a cross-sectional shape with Rk represented by a multivalued function of θk. As shown in FIG. 5, a shape in which a plurality of radial Rk at a particular θk are generated with respect to a certain origin is not applicable as an initial shape. However, there may occur a case where Rk is represented by a multivalued function of θk and a case where Rk is not represented by a multivalued function of θk depending on the origin-setting method. By setting the origin position separately from the centroid position of the cross-sectional shape of each of the layers, the initial shape can be set so that Rk is not represented by the multivalued function of θk. In this case, one of the centroid position and the origin position can be represented by the relative position of the other. Note that the origin position and the centroid position may coincide with each other. In this case, the amount of information to be processed can be reduced.

The layers adjacent to each other in the stacking direction of the slice layers are actually continuously bonded to each other. Therefore, it is preferable to apply such a constraint condition of continuity to perform fitting. Thus, the result of the simulation can be easily converged, and a result close to the actual shape can be obtained while suppressing the calculation burden. For example, there is a method of adding a weight such that the path integration of the cross section is also minimized by the least squares method. In the analysis, in order to determine the cross-sectional shape, a plurality of pieces of diffracted image data acquired with rotating the sample are obtained.

### [Entire System]

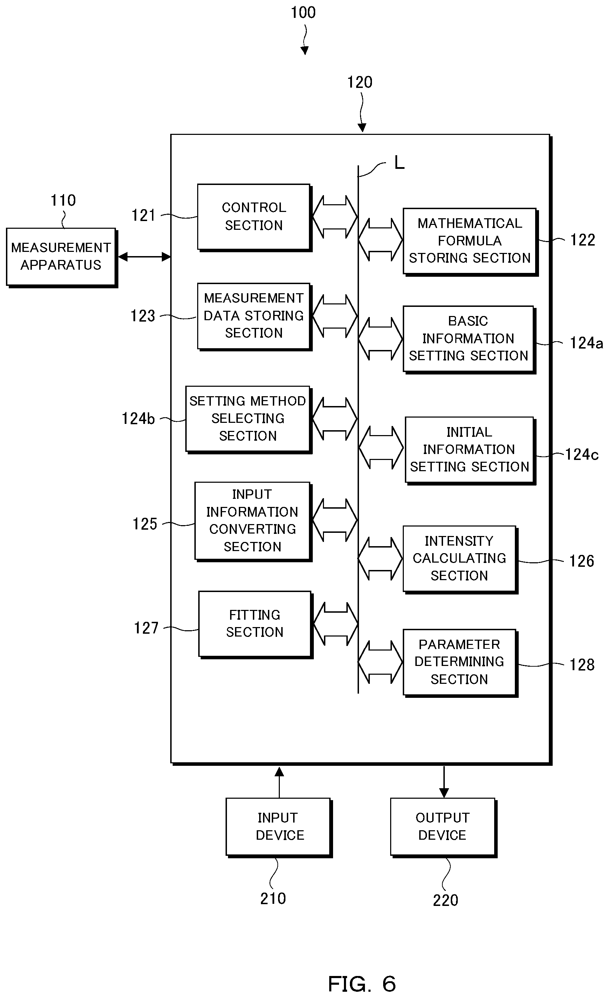

FIG. 6 is a block diagram showing a configuration of the measurement system 100. The measurement system 100 comprises a measurement apparatus 110 and an analysis apparatus 120 and irradiates the plate-shaped sample with X-rays to enable measurement of a transmission CD-SAXS by measuring the scattering intensity. The analysis apparatus 120 controls the measurement apparatus 110, manages the measurement data together with the control data, and enables analysis of the data. A specific configuration is described below.

### [Measurement Apparatus]

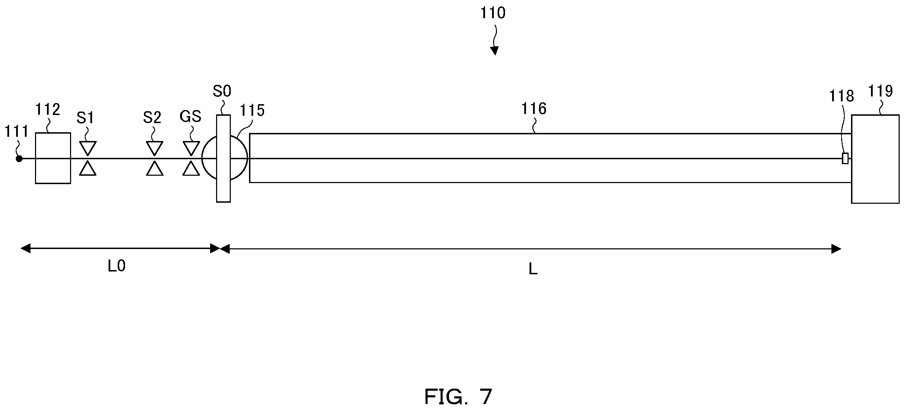

FIG. 7 is a plan view showing a configuration of the measurement apparatus 110. The measurement apparatus 110 comprises an X-ray source 111, a mirror 112, a slit S1, S2 and GS, a sample stage 115, a vacuum path 116, a beam stopper 11, and a detector 119. For example, the distance L0 from the X-ray source 111 to the sample S0 and the camera length L can be set to 1000mm and 3000mm, respectively.

MoKα radiation can be used as the X-ray source 111. The mirror 112 disperses the X-rays emitted from the X-ray source 111 and irradiates the dispersed X-rays toward the sample S0. The slits S1and S2 are formed of members capable of shielding X-rays and configures slit parts for narrowing the dispersed X-rays. With such a configuration, X-rays can be irradiated at a plurality of rotational angles ω which are close to the direction perpendicular to the surface of the plate-shaped sample S0. It is preferable to select specific angles in the range of -10° to 10° for the plurality of rotation angles ω. The slit GS can limit the spot-size of the X-rays on the surface of the sample to a few tens of micrometers or less. Basically, the beam size is determined by the slit S1 and S2, and the parasitic scatterings generated in the slit S1 and S2 are removed by using the slit GS. However, if very small spots are to be generated, the beams can be made smaller with the slit GS.

The sample stage 115 supports the sample S0 on the table, and the orientation of the plate-shaped sample S0 can be adjusted by a driving mechanism under the control of the analysis apparatus 120. Specifically, not only the ω rotation angle around Q_{Y} shown in FIG. 1 but also the χ rotation angle and the φ rotation angle can be adjusted. By such adjusting, it is possible to change the incident angle of the dispersed X-ray into the sample S0 and measure the scattering intensity according to the diffraction angle.

The sample S0 is formed in a plate shape, and the scattering bodies are periodically arranged in directions parallel to the main surface of the sample. An example of the scattering body is a hole. That is, a typical sample is a substrate of a silicon wafer, and in that case the scattering bodies are holes formed by etching. It is important that the higher the integration degree, the more accurate hole shape formation can be confirmed with respect to the specification.

In such cases, even if the length of the scattering body is 200nm or larger and 20µm or smaller, as shown in FIG. 7, by irradiating X-rays perpendicularly to the sample surface and utilizing the scattering accompanied with the transmission of X-rays, it is possible to specify the shape of the scattering body that is long in the thickness direction.

The scattering body is not limited to the above-described hole and may be a pillar. That is, the present invention can also be applied to a sample of a silicon substrate in which cylinders are periodically formed on the surface. Alternatively, a sample in which a line pattern (space pattern) such as a long molecular arrangement is formed may be measured.

The vacuum path 116 maintains the path of the scattered beam under vacuum to prevent attenuation of the beam while securing the camera length long. The beam stopper 118 absorbs the direct beam. The detector 119 is, for example, a two-dimensional detector of a semiconductor capable of moving on a circle with a center of the sample position and is capable of detecting the scattering intensity of X-rays. The measurement apparatus 110 and the analysis apparatus 120 are connected to each other, and the detected scattering intensity data is transmitted to the analysis apparatus 120.

It is preferable that the measurement apparatus 110 comprises a laser light source and a detector for reflected light. It is possible to adjust the orientation of the plate-shaped sample so that the surface of the plate-shaped sample is perpendicular to the incident direction of the X-rays using the reflection of the laser beam. The orientation adjusted in this way can be used as a reference, where ω=χ=0°.

When evaluating the cross-sectional shape of a sample, the analysis itself can be performed without any references. However, the cross-sectional shape specified in this way is only based on the appropriate origin of the ω and χ axes of the goniometer axis. In many cases of evaluating the cross-sectional shape, it is required to evaluate the cross-sectional shape with respect to the surface. In such a case, it is desirable to perform the measurement and analysis after the reference of the surface has been decided.

### [Analysis Apparatus]

The analysis apparatus 120 comprises, for example, a PC including memories and processors and can execute respective processes by executing programs. By processing the measurement data acquired from the measurement apparatus 110, it is possible to analyze the fine structure of a plate-shaped sample formed by periodically arranging scattering bodies long in the thickness direction. The analysis apparatus 120 is capable of not only model-free analysis but also model-based analysis. The configuration described in Patent Document 1 can be used for the model-based analysis.

The analysis apparatus 120 comprises a control section 121, a mathematical formula storing section 122, a measurement data storing section 123, a basic information setting section 124a, a setting method selecting section 124b, an initial information setting section 124c, an input information converting section 125, an intensity calculating section 126, a fitting section 127, and a parameter determining section 128. Each section can transmit and receive information via the control bus L. The inputting device 210 and the outputting device 220 are connected to the CPU via an appropriate interface.

And the analysis apparatus 120 are apparatuses comprising CPU and memories and may be PC terminals or servers on the cloud. Not only the whole apparatus but also part of the apparatus or some functions of the apparatus may be provided on the cloud. The input device 210 is, for example, a keyboard or a mouse, and receives selection and designation by a user, and performs input to the analysis apparatus 120. The output device 220 is, for example, a display, and displays a scattering profile output from the analysis apparatus 120, a UI for setting initial information and the like.

The control section 121 controls the measurement apparatus 110 and manages control data and measurement data. For example, the control section 121 controls the sample stage by the driving mechanism to adjust the azimuth of the sample. The mathematical formula storing section 122 stores a mathematical expression for calculating the scattering intensity for a specific shape model or analysis condition. The measurement data storing section 123 stores the intensity data of the X-rays scattered from the plate-shaped sample accompanied with the X-ray transmission measured at a plurality of ω rotation angles in the vicinity of the vertical direction with respect to the surface of the plate-shaped sample.

The basic information setting section 124a sets basic information. For example, an initial value of the density ρ[j], the thickness t[j], and the origin position (ΔX[j], ΔY[j]) of the scattering body is given for each layer sliced at each depth.

The setting method selecting section 124b selects a model-based analysis in which the cross-sectional shape is a predetermined shape or a model-free analysis in which the cross-sectional shape is an arbitrary shape based on the user's selection information. In the model-free analysis, whether the initial shapes are set in all layers or the cross-sectional shape of one layer and the magnification ratio of each layer are set is selected based on the user's selection information.

The initial information setting section 124c sets the initial cross-sectional shape of each of the layers when the fitting is repeated by changing the cross-sectional shape of each of the layers under specific conditions. The specific condition is a condition that a scattering body is formed by stacking layers each having a constant cross-sectional shape in the thickness direction of the plate-shaped sample. The above-described constant cross-sectional shape is represented by angles and radii when the origin is the center. If the angle is specified in the k-th position when 360° is divided by a predetermined number, the amount of information can be reduced, and the processing efficiency can be improved.

The initial information setting section 124c can set a predetermined shape as the initial cross-sectional shape of each layer when the fitting is repeated by changing the cross-sectional shape of each layer. Thus, a predetermined shape such as an elliptical shape or a oval shape can be set as an initial shape, and the setting is facilitated.

The initial information setting section 124c can also set a shape set using the image data of the plate-shaped sample as the initial cross-sectional shape of each of the layers. Thus, the shape of the default scattered body can be specified using, for example, an image of an electron microscope. In this case, the measurement data can be used to eliminate the arbitrariness of setting.

The initial information setting section 124c may set a shape determined by parameters obtained by model-based analysis as an initial cross-sectional shape of each of the layers. That is, first, the analysis is performed under the condition that the cross-sectional shape of each layer is fixed in a regular shape, and the obtained result can be adopted as an initial condition. Thus, it is possible to use a cross-sectional shape that is ensured to have a certain degree of validity for initial setting, and to prepare an appropriate parameter that is easy to induce convergence.

The input information converting section 125 converts the designation information of the shape received from the user using the freeform tool, as the initial cross-sectional shape of each layer, into the setting information of the shape. Thus, the workload of the user who inputs N points one by one in order to designate the cross-sectional shape can be reduced.

The intensity calculating section 126 calculates the scattering intensity of the X-rays scattered by the plate-shaped sample under a specific condition. The intensity calculating section 126 obtains a mathematical formula for calculating scattering with respect to a desired shape model or analysis condition from the mathematical expression storing section 122 and calculates the scattering intensity of the X-ray using the mathematical expression and the set values of various parameters. By using the obtained mathematical formula, the scattering intensity of X-rays scattered by the plate-shaped sample under specific conditions can be calculated.

The fitting section 127 fits the scattering intensity calculated by the intensity calculating section 126 to the scattering intensity of the X-ray measured by the measurement apparatus 110. The fitting section 127 confirms whether or not the fitting performed is optimal, and when the fitting is not optimal, changes the parameters and causes the scattering intensity to be calculated by simulation again.

The parameter determining section 128 determines parameters of the scattering body in the plate-shaped sample by using a result of fitting. Specifically, angles and radii representing a cross-sectional shape of each layer are determined. In this way, it is possible to determine the shape of the scattering body long in the thickness direction, to accurately analyze the scattering body having a complicated cross-sectional shape and to improve the robustness of the analysis.

The parameter determining section 128 may calculate the centroid position of the cross-sectional shape of each of the layers as the relative position with respect to the origin. Thus, a point independent of the centroid position of the cross-sectional shape of the scattering body can be used as an origin, and various cross-sectional shapes can be handled without using the radius as a multivalued function of the angle.

The parameter determining section 128 can also determine conditions for using the model-based analysis assuming the fixing of the cross-sectional shape based on the angles and the radii representing the cross-sectional shape of each of the determined layers. Thus, in the same case, a model can be set, and efficient analysis can be performed.

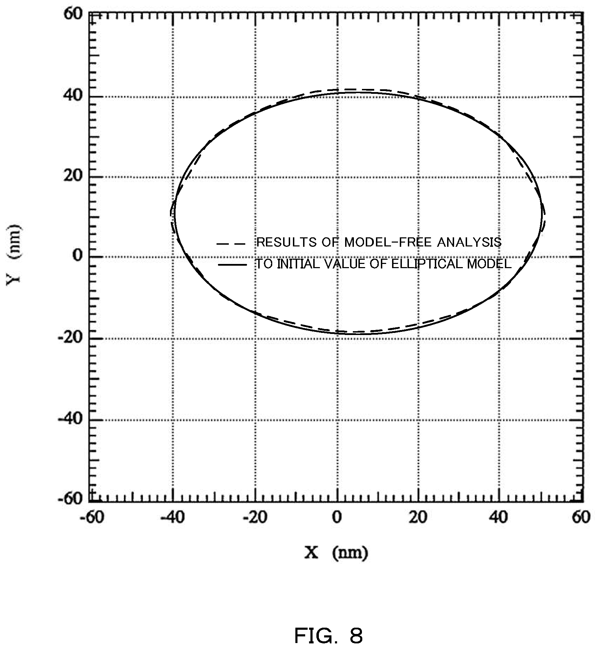

For example, XY cross-sectional shape obtained by the model-free analysis can be fitted with a shape used for the model-based analysis, and the obtained shape can be applied to an initial value of the model-based analysis. FIG. 8 is a diagram showing an example in which a shape obtained by model-free analysis is approximated by an elliptical model. The shape obtained by the model-free analysis is indicated by a broken line, and the ellipse obtained by the fitting is indicated by a solid line. In the example shown in FIG. 8, a model-based analysis is performed using an ellipse represented by the solid line as a constant cross-sectional shape, and the process can be made efficient.

### [Measurement and Analysis Method]

### (Overall Flow)

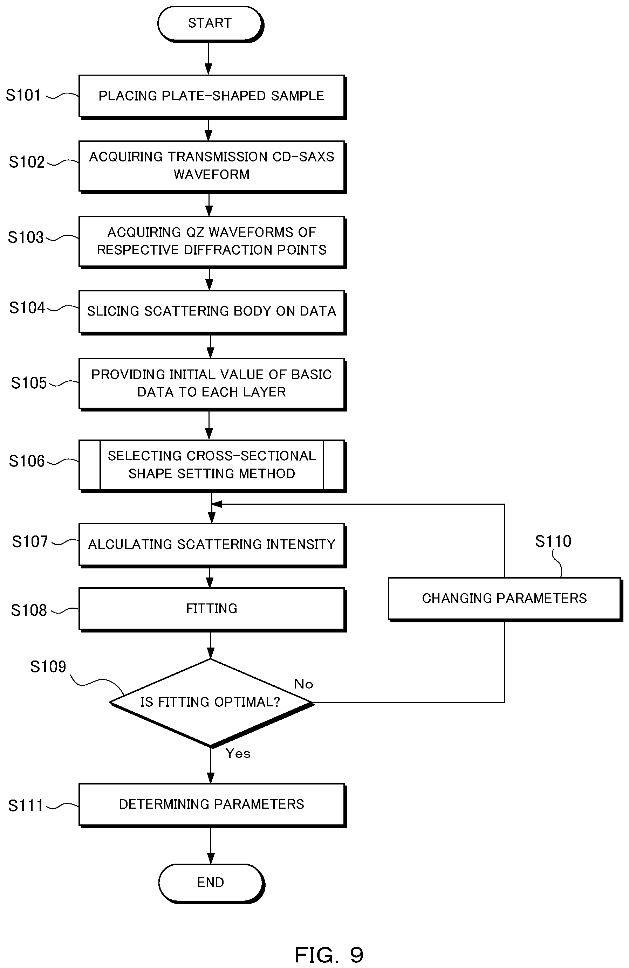

Next, a measurement and analysis method using the configuration of the above-described system is described. FIG. 9 is a flowchart showing a method of measurement and analysis. As shown in FIG. 9, first, a plate-shaped sample is placed (step S101). At the time, the sample surface normal is set to be parallel to the X-ray. Then, the scattered intensities at a plurality of ω rotational angles are measured, and a transmission CD-SAXS waveform is acquired (step S102).

Based on the measured data, Q_{Z} waveforms of the respective diffraction points are obtained (step S103). Then, division and slice are appropriately performed with respect to the depth direction (step S104), and the initial values of the density ρ[j], the thickness t[j] and the origin position (ΔX[j], ΔY[j]) of the scattering body are given for each slice layer (step S105).

Next, a setting method of the cross-sectional shape is selected (step S106). Specifically, as a method of setting the cross-sectional shape of the scattering body, a kind of model-free analysis or a model-based analysis is selected. Details are described below.

Under such conditions, physical parameters are assumed, and the scattering intensity of the X-ray is calculated (step S107). Then, the calculated scattering intensity is fitted to the measured scattering intensity (step S108). It is checked whether or not the fitting performed is optimal (step S109), and if not, the parameters are changed (step S110), and the process returns to step S107. The parameters include density, thickness, origin, angle, and radius of each cross-sectional shape. If the fitting is optimal, then the parameters are determined (step S111) and the sequence is terminated.

### (Selection of Cross-Sectional Shape Setting Method)

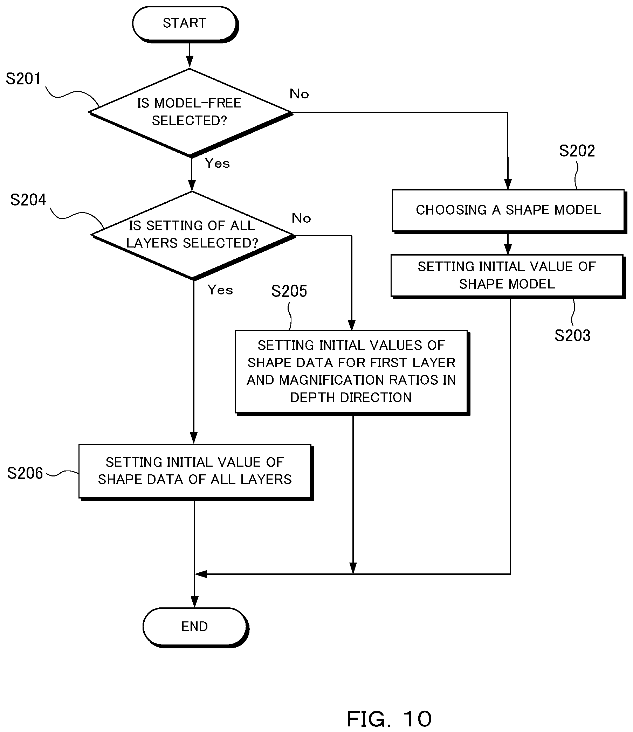

The selection of the cross-sectional shape setting method among the above-described series of steps is described below. FIG. 10 is a flowchart showing selection of a cross-sectional shape setting method. The selection in this flowchart is basically based on information input by the user but may be automatically selected according to some flag.

First, it is determined whether or not model-free analysis has been selected (step S201). When the model-free analysis is not selected, a predetermined cross-sectional shape is selected as the shape model of each layer in the model-based analysis (step S202). The predetermined cross-sectional shape includes an elliptical, a polygon, a drop shape, an egg shape, a snowman shape and a dumpling shape. These shapes also include those in which the corners have a constant curvature.

Then, an initial value of the shape model is set (step S203), and the selection of the cross-sectional shape setting method is completed. For example, when an ellipse is selected, the center, the long diameter, the short diameter of the ellipse and the rotation direction of the long diameter of the ellipse are set as initial values. When a rectangle is selected, the center, the long side, the short side of the rectangle, and the rotation direction of the long side of the rectangle are set as initial value.

On the other hand, when the model-free analysis is selected in step S201, it is determined whether or not the setting of all the layers when the scattering body is sliced at the respective Z positions is selected (step S204). When the setting of all the layers is not selected, a scattering body in which the cross-sectional shapes of all the layers are similar to each other is set. In other words, the shape data of the first layer and the magnification ratios in the depth direction are set as the initial information (step S205). The shape data is represented by the origin position, the angles and radii when the origin are centered. Further, the shape data of, not only the first layer but also the specific layer, may be set as a reference, and the magnification ratios of the other layers may be set.

When the setting of all layers is selected in step S204, the initial values of the shape data of all the layers is set (step S206). Since the initial values of the shape data are set over all the layers, the shape can be accurately analyzed when the cross-sectional shape of the scattering body changes according to the depth or when the scattering body has a complicated shape.

### (Setting by Similar Form)

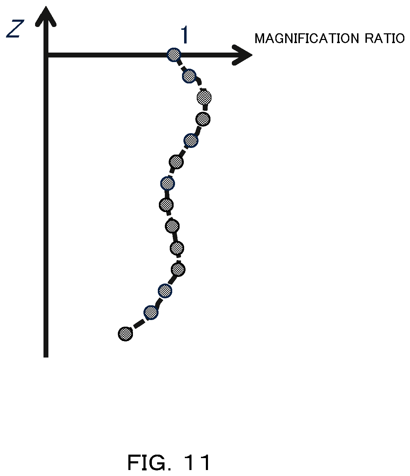

It is also possible to set a scattering body in which the cross-sectional shapes of all layers are similar to each other as initial information. In this case, the user may designate the cross-sectional shape of the specific layer and the magnification ratios of the other layer as initial conditions. FIG.11 is a diagram showing magnification ratios for respective slice layers of a scattering body. For example, as shown in FIG. 11, different magnification ratios are set for the layers at the positions of Z with respect to the first layer.

In this case, the intensity calculating section 126 calculates the scattering intensity on condition that the shapes of the layers constituting the scattering body are similar to each other. Thus, when the shape of the scattering body is not substantially different between the adjacent layers, the shape of the scattering body can be analyzed with reducing the parameter.

For example, Rk of X-Y cross section of the outermost surface and the magnification ratios of the slices excluding the surface can be used as parameters for the analysis. If X-Y cross section is assumed to be a similar shape, the number of parameters can be reduced, so that the analysis time can be shortened. When X-Y cross-sectional shape is completely model-free also in the depth direction, the number of parameters is the multiplied result of the number of divisions of X-Y cross-sectional shape by the number of divisions in the depth direction. However, if X-Y cross-sectional shape is conditioned to be similar in the depth direction, the number of parameters is the number of divisions of X-Y cross-sectional shape plus the number of divisions in the depth direction minus 1.

### (Setting with Free Form Tool)

A freeform tool may be made available at the time of initial setting of the cross-sectional shape. Setting the radius of each angle is burdensome for the user. Especially, the setting of all layers is burdensome. In such a case, the setting with the free form tool is effective.

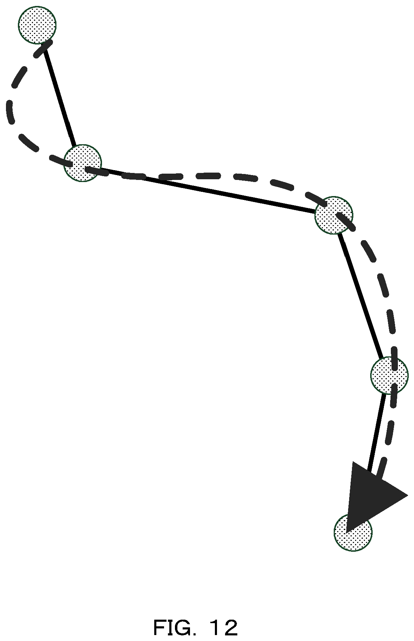

FIG. 12 is a diagram showing a figure set by a freeform tool. As shown in FIG. 12, a curve can be specified along a dashed arrow by clicking the mouse at the inflection point while moving the pointer. The initial information of the cross-sectional shape can be specified by converting the specified curve into information of the radius at each angle. It should be noted that various methods of specifying curves can be adopted as the free form tool. The mouse may be clicked only at the start point and the end point, and the intermediate portion may be formed only by moving the pointer, or the point at the time of clicking may be connected by a straight line. The mouse click may be substituted by a finger touch.

The described above model-free analysis according to the present invention can be applied particularly to the field of semiconductor devices and enables analyzing any shapes of finely-processed patterns formed on the wafer surface with high robust from experimental data acquired by transmission CD-SAXS.

### [Example]

Analyses were carried out with changing the condition for the model of the plate-shaped sample in which the scattering body long in the depth direction was periodically arranged in the direction parallel to the surface. In both cases, a true shape was assumed instead of an actual measurement, and a scattering profile calculated from the assumption was used as an actual measurement value. In example 1, the model-free analysis for changing the cross-sectional shape of each layer was compared with the model-based analysis for fixing the cross-sectional shape to a predetermined shape over all the layers. In example 2, a model-free analysis using shapes similar to a shape initially set as a cross-sectional shape for all layers was compared with a model-based analysis in which the cross-sectional shape was fixed to a predetermined shape over all layers. The R factor indicates the degree of deviation of the calculated value from the measured value.

### (Example 1)

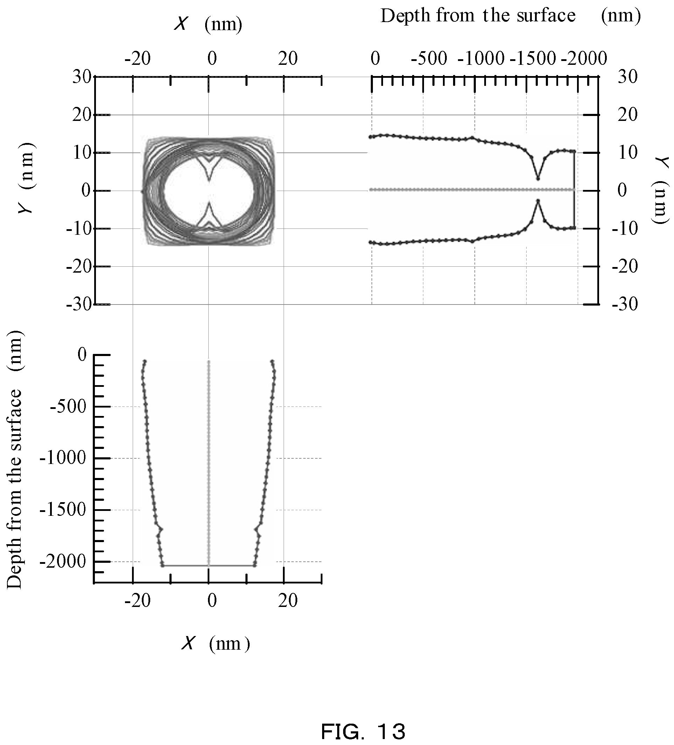

As a true shape, the shape in which XY cross-sectional shape changes one after another into ellipse, rounded rectangle, rectangle, rounded rectangle, ellipse, oval, drop, oval, ellipse, snowman, dumpling, snowman and ellipse for increasing Z is assumed. FIG. 13 is a diagram showing respective cross-sectional shapes of a scattering body set as a true shape. XY plane shows the superposition of the cross-sectional shapes of the individual layers of the scattering body. ZY plane and ZX plane respectively show the cross-sectional shape in the middle of the scattering body.

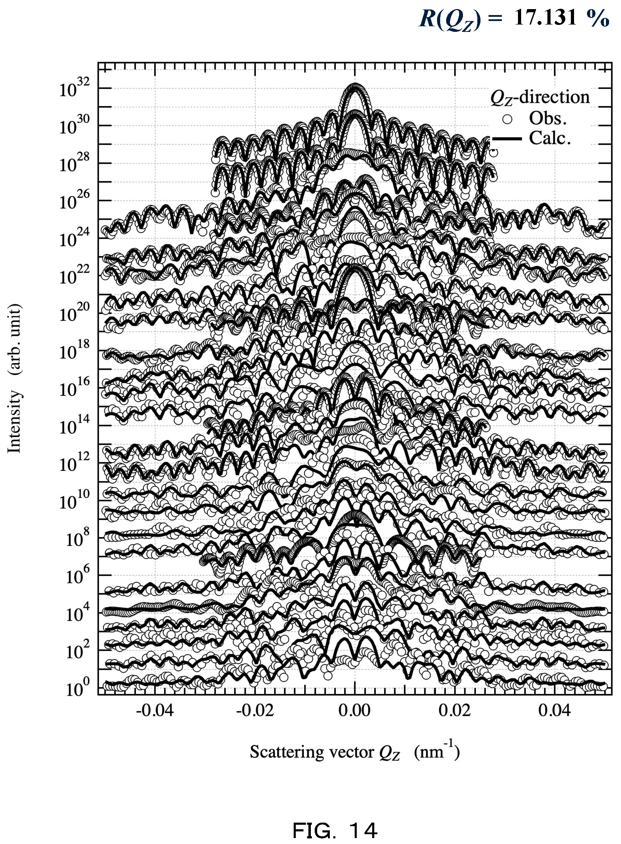

For such a true shape, the model-based analysis was carried out by fixing the cross-sectional shape to a constant ellipse. FIG. 14 is a graph showing scattering profiles performed fitting by assuming a constant ellipse as a cross-sectional shape with respect to measured scattering profiles in Q_{Z} direction. As shown in FIG. 14, with using the model-based analysis, the scattering profiles differed slightly from each other, and R(Q_{Z})=17.131% was obtained as the R factor in Q_{Z} direction.

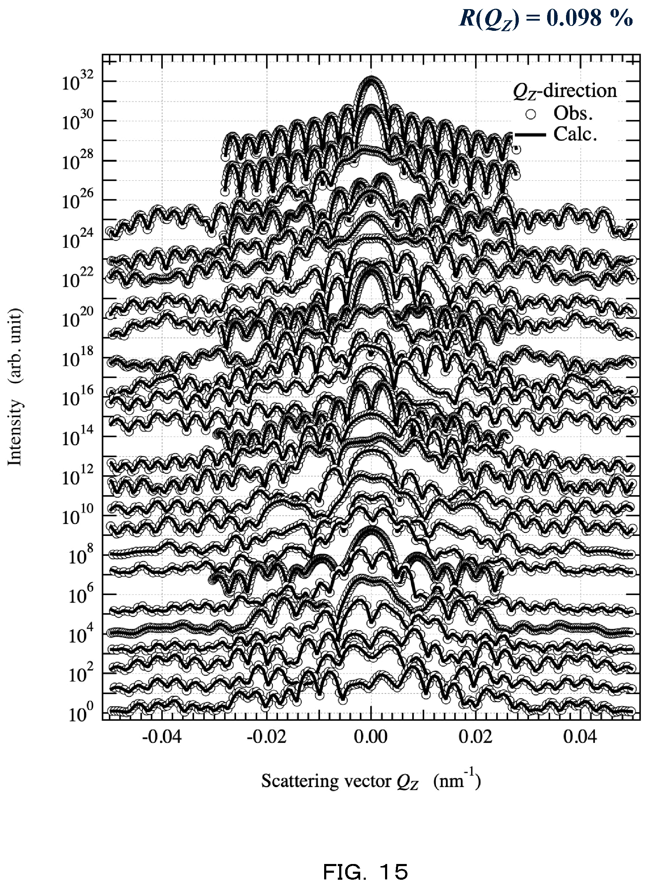

Next, model-free analysis was performed by setting the initial cross-sectional shape to a constant elliptical. FIG. 15 is a graph showing scattering profiles performed fitting by assuming a model-free shape as a cross-sectional shape with respect to measured scattering profiles in Q_{Z} direction. As shown in FIG. 15, with using the model-free analysis, the scattering profiles coincide almost perfectly with each other, and R(Q_{Z})=0.098% is obtained as the R factor in Q_{Z} direction.

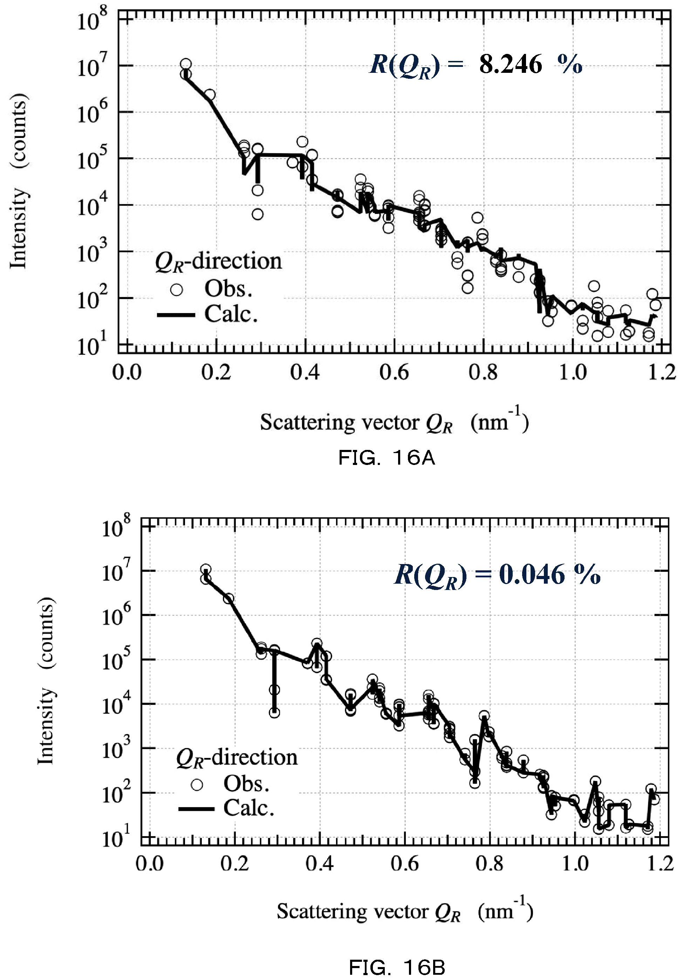

FIGS. 16A and 16B are graphs of scattering profiles performed fitting by assuming a constant ellipse and a model-free shape as respective cross-sectional shapes in Q_{R} direction, respectively. Also, as for Q_{R} direction, with using the model-based analysis in which a constant ellipse is fixed as the cross-sectional shape, the scattering profiles deviate from each other, and R(Q_{R})=8.246% is obtained as the R factor in Q_{R} direction. On the other hand, with using the model-free analysis, the scattering profiles almost perfectly coincide with each other, and R(Q_{R})=0.049% is obtained as the R factor in Q_{R} direction.

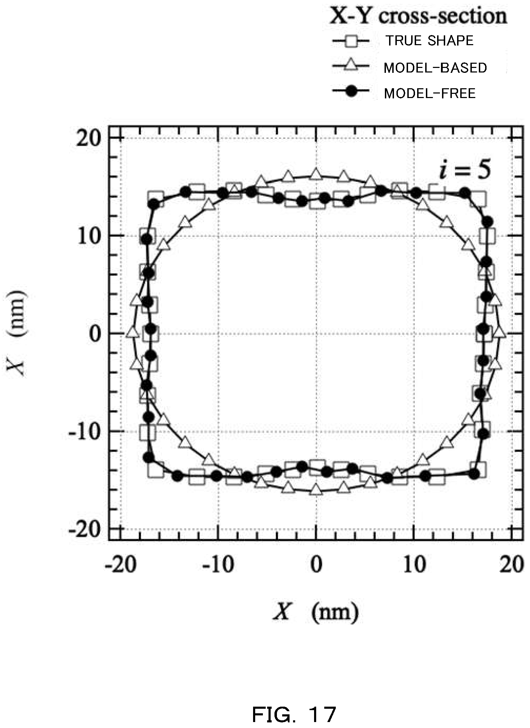

In fact, there was a clear difference between the shape obtained by the model-based analysis and the shape obtained by the model-free analysis for the layer with the distinctive cross-sectional shape. FIG. 17 is a diagram showing cross-sectional shapes at i=5 of a scattering body performed fitting by assuming a constant ellipse and a model-free shape as a cross-sectional shape. "i" indicates the number of the slice layer stacked in the Z direction. In the model-based analysis with fixing a constant ellipse, a part of the ellipse obtained as a result of the analysis just overlaps with a square representing a true shape. However, the shape obtained by the model-free analysis is a square almost same as the true shape.

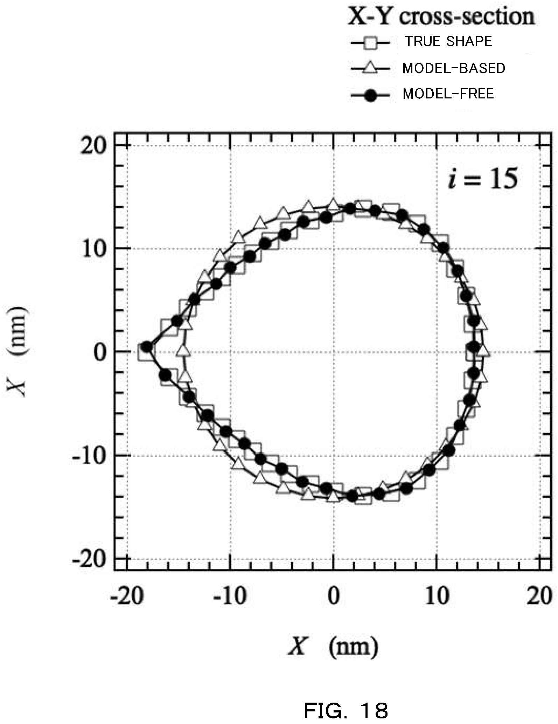

FIG. 18 is a diagram showing cross-sectional shapes at i=15 of a scattering body performed fitting by assuming a constant ellipse and a model-free shape as a cross-sectional shape. In the model-based analysis, an ellipse that is close to a drop shape representing a true shape is obtained, but it is still just an ellipse. However, the shape obtained by the model-free analysis is a drop shape almost same as the true shape.

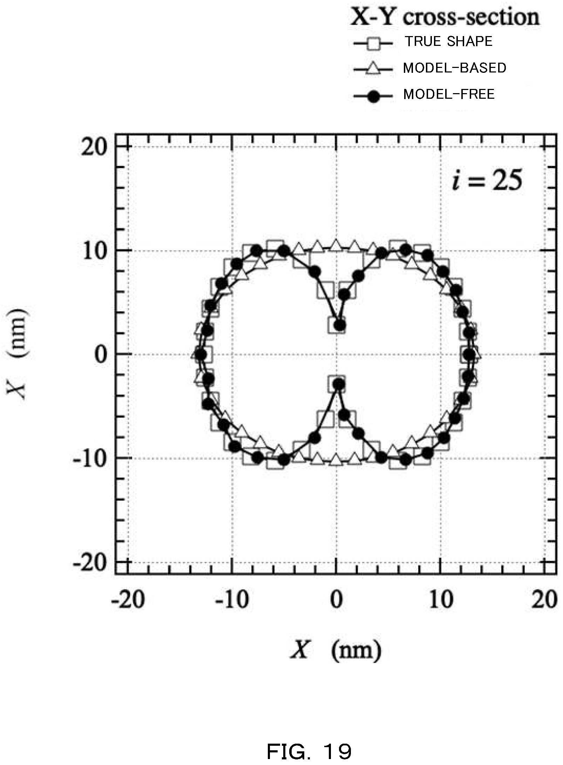

FIG. 19 is a diagram showing cross-sectional shapes at i=25 of a scattering body performed fitting by assuming a constant ellipse and a model-free shape as a cross-sectional shape. In the model-based analysis with fixing a constant ellipse, the obtained ellipse just overlaps with a dumpling shape of the true shape at both ends. However, the shape obtained by the model-free analysis is a dumpling shape almost same as the true shape.

### (Example 2)

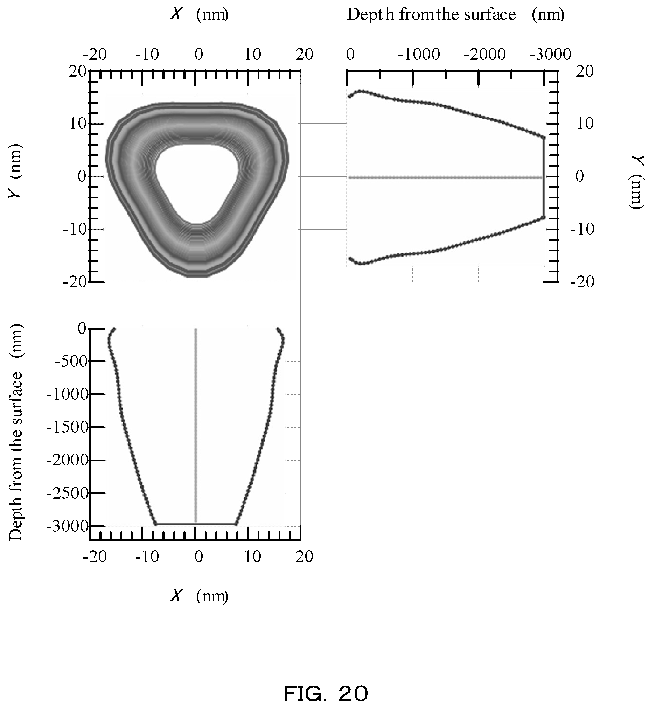

As a true shape, it is assumed that XY cross-sectional shape has a triangle (rice ball shape) having corners of constant curvature for all, and only the sizes are different in the depth direction (Z direction). That is, XY cross-sectional shapes having different depths are similar to each other. FIG. 20 is a diagram showing a shape of each cross section of a scattering body set as a true shape. The superposition of the cross-sectional shapes of the individual layers of the scattering body is shown on XY plane. The cross-sectional shapes in the middle of the scattering body are shown on ZY plane and ZX plane, respectively. As shown in FIG. 20, XY cross-sectional shapes of the respective layers are similar to each other.

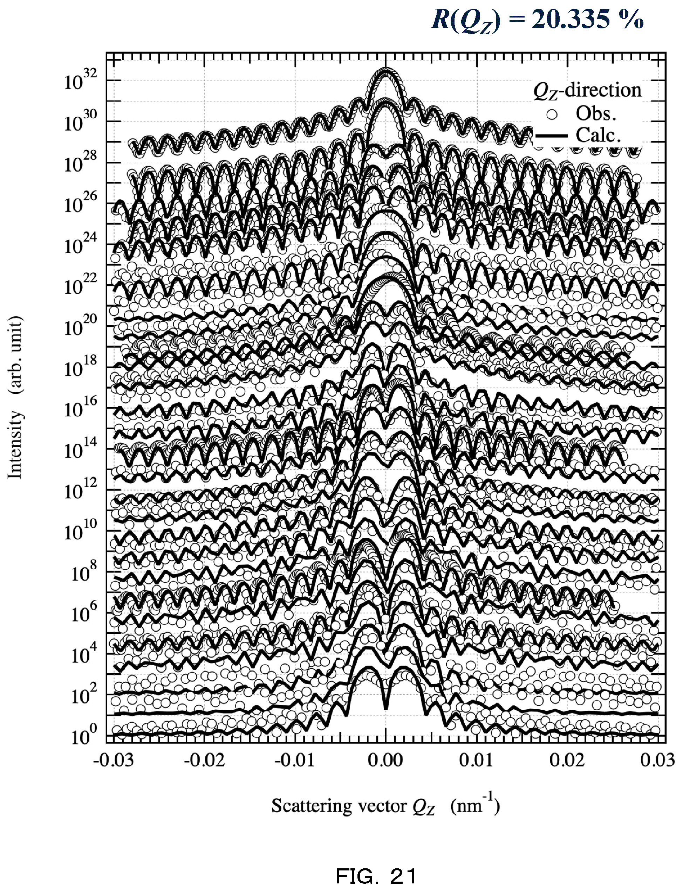

For such true shape, the model-based analysis was performed in which the cross-sectional shape was fixed to a constant circle. FIG. 21 is a graph showing scattering profiles performed fitting by assuming a constant circle as a cross-sectional shape with respect to measured scattering profiles in Q_{Z} direction. As shown in FIG. 21, with using the model-based analysis, the scattering profiles of each other were slightly different, and R(Q_{Z})=20.335% was obtained as R factor in Q_{Z} direction.

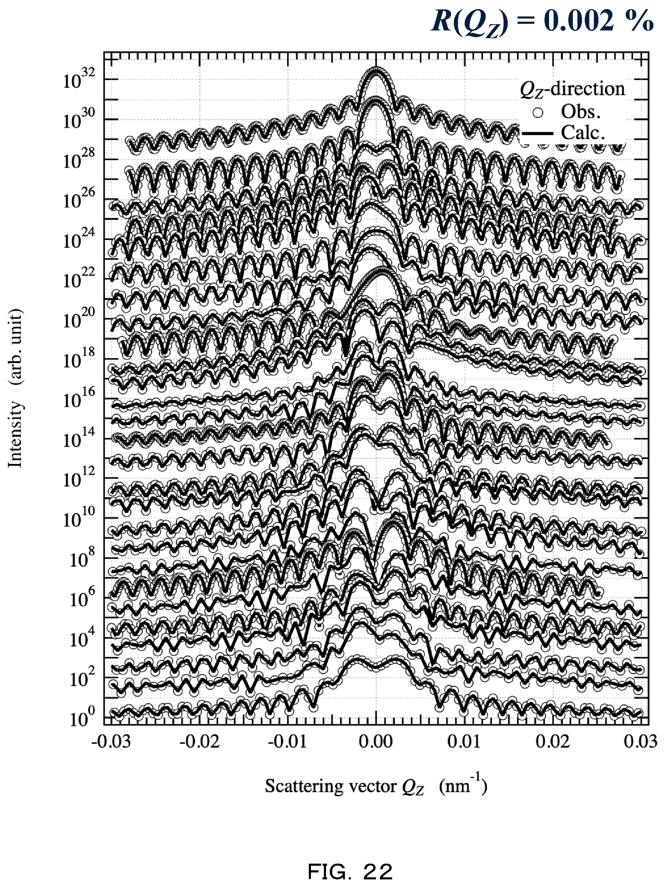

Next, model-free analysis was carried out under the condition that the cross-sectional shape of each layer is similar, by setting the initial cross-sectional shape to a constant circle. FIG. 22 is a graph showing scattering profiles performed fitting by assuming a model-free shape as a cross-sectional shape with respect to measured scattering profiles in Q_{Z} direction. As shown in FIG. 22, with using the model-free analysis, the scattering profiles coincide almost perfectly with each other, and R(Q_{Z})=0.002% is obtained as R factor in Q_{Z} direction.

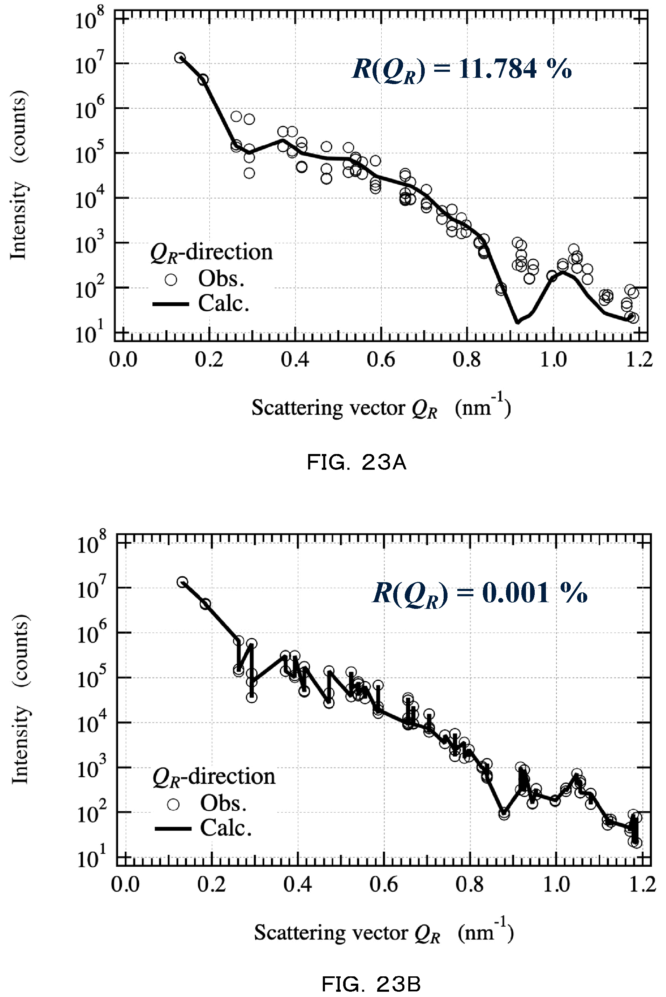

FIGS. 23A and 23B are graphs of scattering profiles performed fitting by assuming a constant circle and a model-free shape as respective cross-sectional shapes in Q_{R} direction, respectively. Also, as for Q_{R} direction, in the model-based analysis in which a constant circle is fixed as the cross-sectional shape, the scattering profiles of each other are deviated, and R(Q_{R})=11.784% is obtained as R factor in Q_{R} direction. On the other hand, with using the model-free analysis, the scattering profiles coincide almost perfectly with each other, and R(Q_{R})=0.001% is obtained as R-factor in Q_{R} direction.

### Description of Symbols

100 measurement system
110 measurement apparatus
111 X-ray source
112 mirror
115 sample stage
116 vacuum path
118 beam stopper
119 detector
120 analysis apparatus
121 control section
122 mathematical formula storing section
123 measurement data storing section
124a basic information setting section
124b setting method selecting section
124c initial information setting section
125 input information converting section
126 intensity calculating section
127 fitting section
128 parameter determining section
210 input device
220 output device
GS slit
S0 sample
S1, S2 slit

## Claims

1. An analysis apparatus for analyzing a fine structure of a plate-shaped sample formed by periodically arranging scattering bodies long in a thickness direction, comprising:
a measurement data storing section for storing data of scattering intensity of X-rays scattered from the plate-shaped sample measured by transmitting X-rays at a plurality of ω rotation angles,
an initial information setting section for setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample,
an intensity calculating section for calculating the scattering intensity of the X-ray scattered by the plate-shaped sample based on the cross-sectional shape of the layer,
a fitting section for fitting the calculated scattering intensity with the measured scattering intensity, and
a parameter determining section for determining the angles and radii representing a cross-sectional shape of the layer by the result of the fitting,
wherein the fitting section repeats fitting by changing the cross-sectional shape of the layer.

2. The analysis apparatus according to claim 1,
wherein the intensity calculating section calculates the scattering intensity under the condition that the shapes of the respective layers constituting the scattering body are similar to each other.

3. The analysis apparatus according to claim 1 or 2,
wherein the initial information setting section sets a predetermined shape as the initial cross-sectional shape of the layer.

4. The analysis apparatus according to claim 1 or 2,
wherein the initial information setting section sets a shape designated by a user as the initial cross-sectional shape of the layer.

5. The analysis apparatus according to claim 4, further comprising an input information converting section for converting the shape designated by the user into the initial cross-sectional shape of the layer using a freeform tool.

6. The analysis apparatus according to claim 1 or 2,
wherein the initial information setting section uses a shape set using image data of the plate-shaped sample as the initial cross-sectional shape of the layer.

7. The analysis apparatus according to claim 1 or 2,
wherein the initial information setting section uses a shape determined by a parameter obtained by model-based analysis as the initial cross-sectional shape of the layer.

8. The analysis apparatus according to claim 1 or 2,
wherein the parameter determining section calculates centroid positions of the cross-sectional shapes of the respective layers as relative positions with respect to the origin.

9. The analysis apparatus according to claim 1 or 2,
wherein the parameter determining section determines the condition for using a model-based analysis in which a cross-sectional shape of the layer is assumed to be constant, based on the angles and radii representing the determined cross-sectional shape of the layer.

10. An analysis method for analyzing a fine structure of a plate-shaped sample formed by periodically arranging scattering bodies long in a thickness direction, comprises the steps of:
preparing data of scattering intensity of X-rays scattered from the plate-shaped sample measured by transmitting X-rays at a plurality of ω rotation angles,
setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample,
calculating the scattering intensity of the X-ray scattered by the plate-shaped sample based on the cross-sectional shape of the layer,
fitting the calculated scattering intensity with the measured scattering intensity, and
determining the angles and radii representing a cross-sectional shape of the layer by the result of the fitting.

11. An analysis program for analyzing a fine structure of a plate-shaped sample formed by periodically arranging scattering bodies long in a thickness direction, causing a computer to execute the process of:
preparing data of scattering intensity of X-rays scattered from the plate-shaped sample measured by transmitting X-rays at a plurality of ω rotation angles,
setting an initial cross-sectional shape at the time of repeating fitting by changing a cross-sectional shape of a layer under the condition that the layer having a constant cross-sectional shape represented by angles and radii around an origin is stacked in a thickness direction of the plate-shaped sample,
calculating the scattering intensity of the X-ray scattered by the plate-shaped sample based on the cross-sectional shape of the layer,
fitting the calculated scattering intensity with the measured scattering intensity, and
determining the angles and radii representing a cross-sectional shape of the layer by the result of the fitting.
